# EUROPEAN PATENT APPLICATION

(11) **EP 3 226 665 A1**
(43) Date of publication of application: **04.10.2017**
(21) Application number: 16305384.6
(22) Date of filing: 31.03.2016
(51) Int. Cl.: H05K 1/02

(54) **TUNABLE SLOT RESONATOR ETCHED AT THE EDGE OF A PRINTED CIRCUIT BOARD**

(71) Applicant: Thomson Licensing, 92130 Issy-les-Moulineaux (FR)
(72) Inventor: JEANNE, Ludovic, 35576 Cesson-Sévigné (FR); MINARD, Philippe, 35576 Cesson-Sévigné (FR); BERTIN, Jean-Pierre, 35576 Cesson-Sévigné (FR); LO HINE TONG, Dominique, 35576 Cesson-Sévigné (FR)
(74) Representative: Huchet, Anne

(57) **Abstract**

A device comprising a slot resonator (140) etched in a printed circuit board (110) comprising a short-circuit plane (142) and a high impedance plane (144), the high impedance plane being located on the edge of a ground plane of the printed circuit board, between two electronic modules (120, 130) hosted on the printed circuit board, the high impedance plane comprising an active component (150) tuned to optimize the noise level of the electronic modules. The overall length of the etching is equal to the quarter guided wave length modulo the half guided wave length of the frequency to be inhibited.

## Description

### TECHNICAL FIELD

The present disclosure relates generally to circuit boards used in electronic devices. It relates more specifically to a slot resonator etched in a printed circuit board and tuned to reduce electromagnetic interferences (EMI) emitted from an electronic module hosted on the printed circuit board of the electronic device or to improve the wireless radiation pattern when the device comprises a wireless interface.

### BACKGROUND

This section is intended to introduce the reader to various aspects of art, which may be related to various aspects of the present disclosure that are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

For many electronic devices, manufacturers are trying to integrate multiple functions in a reduced space, therefore leading to close proximity between the different electronic modules. In some cases, electronic modules generate conducted and radiated electromagnetic interferences (EMI) that disturb the operation of another electronic module. This is particularly critical when one of the modules is a wireless communication device operating at radio frequencies. Moreover, the electronic modules may generate such inferences randomly, as a result of certain activities such as for example transfer of bursts of data, thus making it difficult to design a mechanism to minimize these interferences statically.

Wireless communication devices often use a small form factor to enhance portability and enable connection to a host device such as a computer or a set top box. In this case, metallic parts for example housing, heat spreader, heatsink, bottom casing, back panel, and ground plane of the host device influence the radiation pattern of the wireless communication device, which can generate transmission errors.

A wireless communication device connected to a host device through a physical connector can get back from this device multiple interferences through this connector either by electrical contact or by electromagnetic coupling between the wireless communications device and the host device.

In a small form factor device (as example a USB or HDMI dongle), EMI issues become more and more difficult to manage due to the small size of the PCB. The conventional design rules to minimize EMI are to set up the high speed traces/lines in the middle of the PCB, but this does not work well when the PCB has the size of the USB dongle or the like since the spread of induced currents from EMI on the edge of the PCB becomes predominant.

It can therefore be appreciated that there is a need for a solution that addresses at least some of the problems of the prior art. The present disclosure provides such a solution.

### SUMMARY

In a first aspect, the disclosure is directed to a device comprising a printed circuit board including a resonator comprising a short-circuit plane and a high impedance plane, characterized by the high impedance plane of the resonator being located on the edge of a ground plane of the printed circuit board, between two electronic modules hosted on the printed circuit board, the high impedance plane comprising an active component configured to minimize the interferences of the electronic modules comprising unwanted frequencies.

In variant embodiments:
- the resonator is a slot resonator etched in at least one layer of the printed circuit board;
- the overall length of the slot resonator etching is equal to a quarter guided wave length of unwanted frequencies modulo the half guided wave length;
- the resonator is a metal strip resonator;
- the active component is one of a switch, a varactor diode, a diode and a transistor;
- the active component is tuned according to the operating modes of the first electronic module, comprising a first mode wherein the first electronic module generates noise signal at a determined frequency and its associated harmonic frequencies and a second mode wherein no noise is generated by the first electronic module; and
- the first electronic module generates noise signal at a determined frequency and its associated harmonic frequencies and the second electronic module has at least a radio frequency receiving mode operating at one of the frequencies generated by the first module.

In a second aspect, the disclosure is directed to a method for tuning a resonator comprising iteratively applying a tuning parameter selected from a set of tuning parameters to the active component of the slot resonator, for each tuning parameter, obtaining quality measures reflecting the impact of the tuning, selecting the tuning parameter that results in the best quality measure, and applying the selected tuning parameter to the active component of the slot resonator. In a first variant embodiment, the quality measure is obtained by receiving a packet-error rate from a remote device to which the device comprising the resonator sent a set of data. In a second variant embodiment, the quality measure is obtained by receiving a signal-to-noise ratio from a remote device to which the device comprising the resonator sent a set of data.

### BRIEF DESCRIPTION OF DRAWINGS

Preferred features of the present disclosure will now be described, by way of non-limiting example, with reference to the accompanying drawings, in which:
Figure 1A illustrates a system with an exemplary wireless communication device in which the disclosure may be implemented;
Figure 1 B illustrates a system with an exemplary interface device in which the disclosure may be implemented;
Figure 2A illustrates a symbolized top view of a layout example of a printed circuit board of the exemplary wireless communication device illustrated in Figure 1 A;
Figure 2B illustrates a symbolized top view of a layout example of a printed circuit board of the exemplary interface device illustrated in Figure 1 B;
Figures 3A, 3B and 3C illustrate different examples of shapes that can be used to constitute a slot resonator of the present disclosure; and
Figure 4 illustrates an example of sequence diagram detailing the method for tuning the slot resonator.

### DESCRIPTION OF EMBODIMENTS

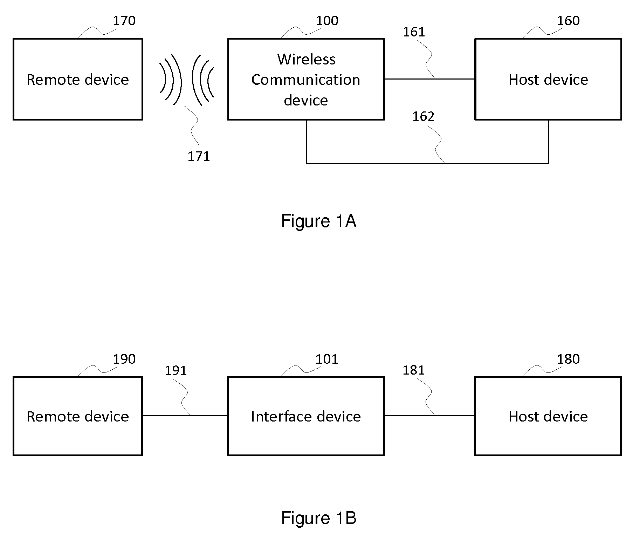

Figure 1A illustrates a system comprising an exemplary wireless communication device in which the solution of the disclosure may be implemented. In a preferred embodiment, a wireless communication device 100 is connected to a host device 160 through a wired connection 161 and interfaces wirelessly with a remote device 170 through a wireless connection 171. In a preferred embodiment, the wired connection 161 implements Universal Serial Bus (USB) technology while the wireless connection 171 uses a proprietary wireless audio protocol to transmit audio signals to wireless loudspeakers. The audio signals are received either through the wired connection 161 from the host device 160 or through a separate wired audio connection 162 from the host device 160 or from another device, not pictured here. The wireless communication device 100 preferably is of small size, equivalent to a conventional USB dongle. In an alternate embodiment, the wireless communication device 100 is also configured to process a video signal. In an alternate embodiment, the wired connection 161 is implemented with High Definition Multimedia Interface (HDMI) technology.

The wireless communication device 100 may be connected to a huge variety of host devices, comprising set-top boxes, computers, audio amplifiers, sound bars, television sets, and many other kind of devices requiring the transmission of sound signals to wireless loudspeakers. Such devices come in different shapes and materials, potentially including large metallic surfaces. In addition, the connector in which the wireless communication device 100 is plugged in can be located in various locations: for example on the front panel, on the rear panel, on the top panel, or on side panels of the host device 160. The person skilled in the art will appreciate that each of these configurations impacts the radiation pattern of the wireless communication device 100 differently. Moreover, the various host devices conventionally process high data rate signals in a plurality of electronic circuits, leading to the transmission of parasitic interferences related to the high data rate signals towards the wireless communication device 100 over the physical connections 161 and 162.

**Figure 1B** illustrates a system comprising an exemplary interface device in which the solution of the disclosure may be implemented. The interface device 101 is connected to a host device 180 through a first connection 181 and interfaces with a second device 190 through a second connection 191. In an alternate embodiment, the connections 181, 191 are implemented as IEEE1394 links or High Definition Multimedia Interface (HDMI) links. For example one application allows conversion of video signals from a camcorder to display on modern TV sets. The interface device 101 receives audio and video signals from the host device 180 through the USB link, converts the signals into HDMI signals and transmits the HDMI signals to the second device 190 through the HDMI link. The interface device 101 preferably is of small size, equivalent to a conventional USB dongle.

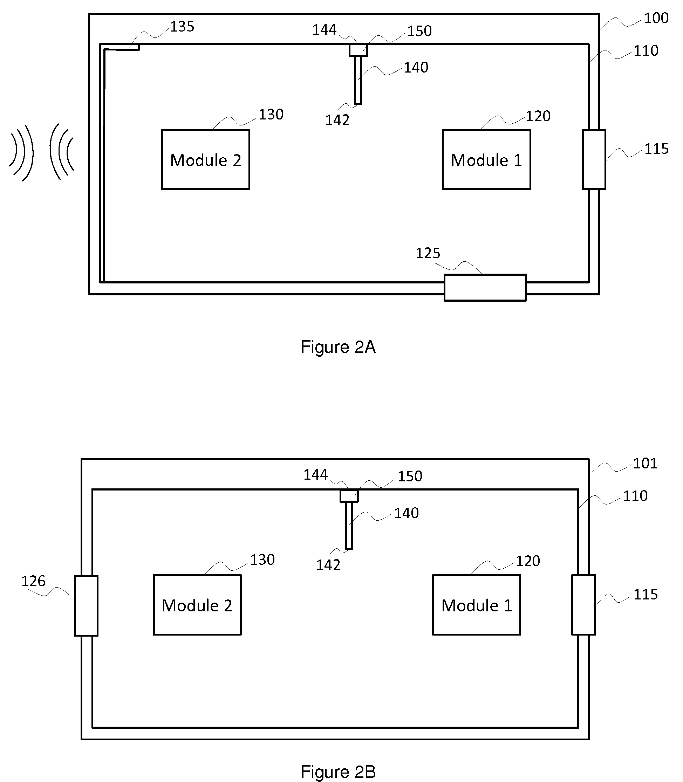

**Figure 2A** illustrates a symbolized top view of a layout example of the exemplary wireless communication device of figure 1 A. The man skilled in the art will appreciate that the illustrated elements are simplified for reasons of clarity. The wireless communication device 100 integrates a printed circuit board 110 hosting a plurality of electronic components implementing the functionalities to be provided. The printed circuit board 110 comprises a connector 115 configured to connect the wireless communication device 100 to the host device 180, a first electronic module 120 configured to provide a first functionality, for example a data caching or format conversion functionality, a second electronic module 130 configured to provide a wireless communication functionality through an antenna 135. A second connector 125 is optionally provided, for example for receiving an audio signal from the host device. The printed circuit board 110 also host traces used to interconnect the plurality of electronic components; the traces can for example comprise power feeding lines, high-speed bus lines and high-frequency clock lines. A slot resonator 140 is etched in a ground plane of the printed circuit board 110 and comprises a short-circuit plane 142 and a high impedance plane 144, also called open-circuit plane, the high impedance plane being located on the edge of the printed circuit board between the two electronic modules 120 and 130, the overall length of the slot resonator 140 being equal to the quarter guided wave length of the parasitic frequency to be attenuated. An active component 150 is located at the high impedance plane. This active component is one of a switch, a diode, a transistor and a varactor diode, the type of switch being either single-pole single-throw, single-pole double-throw or single-pole multiple-throw. In the preferred embodiment, a varactor diode is used, allowing richer tuning capabilities.

The slot resonator 140 can be tuned by altering the parameters of the active component. The equivalent circuit of the slot resonator 140 can be given as a parallel RLC model. As an example, a varactor diode can be represented as a parallel variable capacitor of the equivalent circuit of the slot resonator 140 and allows the tuning of the resonant frequency of the assembly formed by the slot resonator 140 and the active component 150. A first effect of such tuning is the modification of the current distribution in the ground plane of the printed circuit board 110, thus reducing the interferences generated by the first electronic module 120 and the host device 180, these interferences being either radiated or conducted.

A second effect is the modification of the radiation pattern of the second electronic module 130, thus reducing the potential impact of the metal housing of the host device 180. On devices with small form factor, the antenna 135 induces currents in most of the nearby metallic parts as well the ground plane of the wireless communication device 100. This initial state results in a first radiation pattern. The slot resonator is placed in the area where the antenna induces interfering currents. The tuning of the slot resonator modifies the current distribution in this area, thus impacting the radiation pattern.

**Figure 2B** illustrates a symbolized top view of a layout example of the exemplary interface device of figure 1 B. The elements are similar to the elements of previous figure, with the exceptions that there is no second connector 125 and the second module 130 does not include any wireless communication functionality and therefore there is no antenna connected to this module. The communication with the second device is done through a connector 126. In the interface device 101, the tuning of the slot resonator has for effect to limit the parasitic interfaces generated by the first electronic module 120 and the host device. In such an example of a device, the resonator is tuned to modify the current distribution in the ground plane of the printed circuit board 110, thus reducing the interferences generated by the first electronic module 120 and the host device 180.

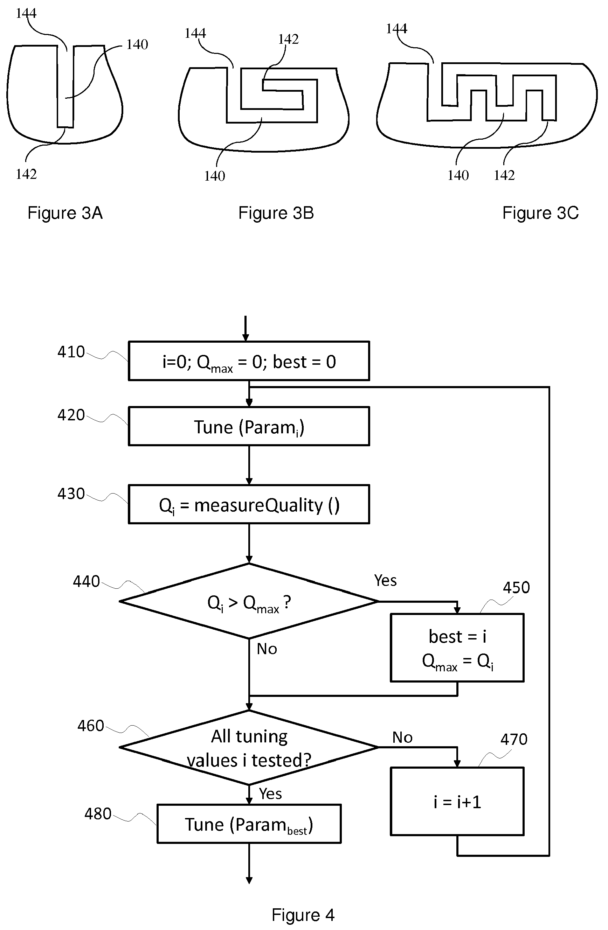

**Figure 3A and 3B** illustrate different examples of shapes that can be used to constitute the slot resonator.

The shape illustrated in figure 3A illustrates a straight slot resonator 140 etched in the ground plane of the printed circuit board. In the example of minimizing interferences at 2.45 GHz, a quarter wavelength slot resonator is designed on a FR4 substrate of total thickness of 1.2mm, having a width of 1 mm and a length of 17mm between the short circuit plane 142 and the open circuit plane 144. The width of the slot resonator is linked to the quality factor of the resonator and can act either on a narrow or wide frequency band.

The shapes illustrated in figure 3B and figure 3C show non-exhaustive ways to meander the slot resonator line etched in the ground plane of a printed circuit board in order to ease the integration in small PCB form factor, where the average length of meandered slot can be adjusted at first order to the length of the straight slot resonator.

Any other slot resonator shapes may be used, for example shapes with non-constant slot width or slots etched on a multi-layered printed circuit board.

The preferred embodiment is based on a printed circuit board but the principle also applies to other supports and manufacturing technologies such as flexible circuits.

**Figure 4** illustrates an example of sequence diagram detailing a method for tuning the slot resonator. A table *Param* contains different possible values of tuning parameters for the active component (150 in Figures 2A and 2B). In step 410, the process is started by initializing variables: an iteration counter *i* is set to zero, an indicator of maximal measured quality *Qₘₐₓ* is set to zero, and an index of the best tuning *best* is set to zero. In step 420, a first tuning parameter *Paramᵢ* is used to configure the active component 150 of figures 2A or 2B. This comprises for example adjusting the capacitance of the component, its inductance, its resistance, or any combination of such adjustments. In step 430, a quality measure is performed and provides a value Q*ᵢ*. The quality measure can be of different type. In the preferred embodiment of the wireless communication device, the packet error rate of the wireless transmission is used, requiring the remote device to send back this value. In an alternate embodiment, a signal-to-noise ratio is measured and used as measure of quality. In step 440, it is checked whether the last measured quality value is higher than the maximal measured quality *Qₘₐₓ.* If the last measured quality value is better, in step 450, the index of the best tuning *best* and the maximal measured quality *Qₘₐₓ* are updated to *i* and Q*ᵢ*, respectively. In step 460, it is checked whether all possible values of tuning parameters have been tested. If it is not the case, in step 470, the iteration counter *i* is incremented and the method continues in step 420. When in step 460 it is detected that all possible values tuning parameters have been tested, then the best tuning parameters *Param_{best}* are applied in step 480.

Applying a tuning parameter *Paramᵢ* to the active component 150 is done conventionally, for example by using some digital-to-analog converter circuit and some electronic circuitry to control the value of the capacitance of the active component.

In an alternate embodiment, the method described in figured 4 is applied only in the case where a first quality measure is performed and resulted in a measured quality lower than a determined threshold.

In an alternate embodiment, the tunable component simply comprises a switch to establish contact across the slot between the two parts of the ground plane. In this case, the device can operate in only two modes; a first mode where the contact is "on" corresponding to a configuration where the slot resonator 150 is closed with a short-circuit at the edge of the printed circuit board and a second mode where the contact is "off" corresponding to a configuration where the slot resonator 150 is not closed. In such an embodiment, the method for tuning the slot resonator described in figure 4 only requires two iterations: one in each mode.

In an alternate embodiment, the tunable component comprises a switch to establish contact across the slot between the two parts of the ground plane and the switch is set directly according to the activity of the first electronic module, without any quality measure. When the first electronic module is active, for example transferring data from the host device, the switch is tuned to the first mode where the contact is "on" therefore being adapted to a first configuration. Conversely, when the first electronic module is inactive, the switch is tuned to the second mode where the contact is "off" therefore being adapted to a second configuration.

## Claims

1. A device (100, 101) comprising a printed circuit board (110) including a resonator (140) comprising a short-circuit plane and a high impedance plane, **characterized by** the high impedance plane of the resonator being located on the edge of a ground plane of the printed circuit board, between two electronic modules (120, 130) hosted on the printed circuit board, the high impedance plane comprising an active component (150) configured to minimize the interferences of the electronic modules (120, 130) comprising unwanted frequencies.

2. The device of claim 1 wherein the resonator is a slot resonator etched in at least one layer of the printed circuit board.

3. The device of claim 2 wherein the overall length of the etching is equal to a quarter guided wave length of unwanted frequencies modulo the half guided wave length.

4. The device of claim 1 wherein the resonator is a metal strip resonator

5. The device of any one of claims 1 to 4 wherein the active component (150) is one of a switch, a varactor diode, a diode and a transistor.

6. The device of any one of claims 1 to 5 wherein the active component (150) is tuned according to the operating modes of the first electronic module (116), comprising a first mode wherein the first electronic module (116) generates noise signal at a determined frequency and its associated harmonic frequencies and a second mode wherein no noise is generated by the first electronic module (116).

7. The device of any one of claims 1 to 6 wherein the first electronic module generates noise signal at a determined frequency and its associated harmonic frequencies and wherein the second electronic module (118) has at least a radio frequency receiving mode operating at one of the frequencies generated by the first module.

8. A method for tuning a resonator comprising:
- iteratively applying a tuning parameter selected from a set of tuning parameters to the active component of the slot resonator;
- for each tuning parameter, obtaining quality measures reflecting the impact of the tuning
- selecting the tuning parameter that results in the best quality measure;
- applying the selected tuning parameter to the active component of the slot resonator.

9. The method of claim 8 wherein the quality measure is obtained by receiving a packet-error rate from a remote device to which the device comprising the resonator sent a set of data.

10. The method of claim 8 wherein the quality measure is obtained by receiving a signal-to-noise ratio from a remote device to which the device comprising the resonator sent a set of data.
